# EUROPÄISCHE PATENTSCHRIFT

(11) **EP 0 662 243 B1**
(45) Veröffentlichungstag und Bekanntmachung des Hinweises auf die Patenterteilung: **19.08.1998**
(21) Anmeldenummer: 93918993.2
(22) Anmeldetag: 14.09.1993
(51) Int. Cl.: G03F 7/09, H01L 21/027

(54) **ANTIREFLEXSCHICHT UND VERFAHREN ZUR LITHOGRAFISCHEN STRUKTURIERUNG EINER SCHICHT**
ANTIREFLEX LAYER AND PROCESS FOR LITHOGRAPHICALLY STRUCTURING SUCH A LAYER
COUCHE ANTIREFLET ET PROCEDE DE STRUCTURATION LITHOGRAPHIQUE D'UNE TELLE COUCHE

(30) Priorität: 18.09.1992 DE 4231312
(43) Veröffentlichungstag der Anmeldung: 12.07.1995
(73) Patentinhaber: SIEMENS AKTIENGESELLSCHAFT, 80333 München (DE)
(72) Erfinder: KÜSTERS, Karl-Heinz, Dr., D-85521 Ottobrunn (DE); KÜPPER, Paul, Dr., D-85625 Glonn (DE); CZECH, Günter, D-80337 München (DE); JOSWIG, Hellmut, Dr., D-81547 München (DE)
(86) Internationale Anmeldenummer: DE9300857
(87) Internationale Veröffentlichungsnummer: WO9407260

(56) Entgegenhaltungen:
- EP-A- 0 098 582
- EP-A- 0 379 604
- DE-A- 3 428 565
- PATENT ABSTRACTS OF JAPAN vol. 013, no. 195 (E-754)10. Mai 1989 & JP,A,01 015 951 (NEC CORP.) 19. Januar 1989
- MICROELECTRONIC ENGINEERING Bd. 21, Nr. 1/4 , April 1993 , AMSTERDAM NL Seiten 51 - 56 XP000361050 G.CZECH ET AL. 'REDUCTION OF LINEWIDTH VARIATION FOR THE GATE CONDUCTOR LEVEL BY LITHOGRAPHY BASED ON A NEW ANTIREFLECTIVE LAYER'

## Beschreibung

Die Erfindung betrifft ein Verfahren zur Strukturierung einer Schicht auf einem Halbleitersubstrat unter Einsatz einer Fotolackmaske und eines Ätzprozesses, eine Halbleiterstruktur mit einer zu strukturierenden Schicht sowie die Verwendung einer aSi/aSiN-Schicht als Antireflexschicht bei der lithografischen Strukturierung von Schichten.

In der Halbleitertechnologie ist bei der lithografischen Strukturierung von aufgebrachten Schichten das Problem störender Reflexionen bekannt. Abhängig von den optischen Eigenschaften wie beispielsweise Brechungsindex und Absorptionskoeffizent der auf dem Halbleitersubstrat aufgebrachten Schichten einschließlich des Fotolacks tritt Reflexion und Brechung des zur Belichtung des Fotolacks eingesetzten Lichts an allen Schichtgrenzflächen auf. Es wird beispielsweise an der Oberfläche der zu strukturierenden Schicht in den Fotolack zurückreflektiert; durch Interferenz und Absorption kommt es zu unerwünschten örtlichen Intensitätsschwankungen.

Durch Antireflexschichten, die vor der Fotolackschicht ganzflächig aufgebracht werden, kann dieses Problem verringert werden. Linienbreite-Variationen aufgrund unterschiedlicher Lackdicken werden reduziert, und der Einfluß von Reflexionen an Kanten wird verringert, wodurch die Verwendung von sogenannten Hochkontrastlacken möglich ist. Die Antireflexschicht befindet sich üblicherweise direkt unter der Fotolackschicht, so daß zunächst die Antireflexschicht geätzt werden muß, bevor die Schicht strukturiert werden kann. Unter anderem um die Maßhaltigkeit bei der Strukturierung zu gewährleisten und die Prozeßdauer möglichst gering zu halten, werden im allgemeinen möglichst dünne Antireflexschichten eingesetzt. Die Wirkung von solchen dünnen Antireflexschichten beruht auf vor allem Interferenzeffekten, und zwar auf Interferenz in der Antireflexschicht bzw. in allen optisch wirksamen, d. h. von der Belichtung erreichten Schichten. Daher sind für Antireflexschichten genaue Schichtdicken einzuhalten, die insbesondere auch von den optischen Eigenschaften aller unterliegenden optisch wirksamen Schichten abhängen. Besitzt eine der unterliegenden Schichten eine unterschiedliche Schichtdicke an verschiedenen Stellen auf dem Halbleitersubstrat, ist eine befriedigende Antireflex-Wirkung kaum zu erreichen.

Es ist bekannt, eine dünne aSi (amorphe Silizium)-Schicht als Antireflexschicht einzusetzen. Ihre Wirkung beruht auf Interferenz und erfordert daher, wie bereits erläutert, eine genau auf die unterliegenden Schichten abgestimmte Schichtdicke in der Größenordnung von wenigen nm, da der Brechungsindex relativ hoch ist (ca. 4 - 5,5). Befriedigende Ergebnisse können nur auf hochreflektierenden Schichten wie Aluminium erzielt werden. Ist die zu strukturierende Schicht teilweise lichtdurchlässig, muß die aSi-Schichtdicke in engeren Grenzen gehalten werden als prozeßtechnisch möglich.

Die Verwendung von Antireflexschichten ist besonders interessant für Polysilizium-oder Polyzid-Schichten, wie sie für Transistorgates verwendet werden. Hierbei ist es auch sehr wichtig, bei der Strukturierung die Toleranzen für die Linienbreiten gering zu halten, da diese direkt die elektrischen Eigenschaften des Schaltkreises bestimmen. Bei den Polysilizium-oder Polyzid-Schichten des Transistorgates ist es oft notwendig, über diesen Schichten eine Oxid-oder Nitridschicht aufzubringen, die mit derselben Fotolackmaske wie die Polysilizium-Schicht strukturiert wird, beispielsweise um einen späteren selbstjustierten Kontakt zu den Source/Drain-Gebieten des Transistors herstellen zu können. Aufgrund der optischen Eigenschaften des kombinierten Schichtsystems, beispielsweise Oxid auf Polysilizium, ist eine Reflexionsunterdrückung nur schwer zu erreichen. Ohne Verwendung einer Antireflexschicht beträgt die Reflektivität etwa 23 bis 36 %, abhängig von der Oxidschichtdicke auf Polysilizium.

Für das Schichtsystem Oxid auf Polysilizium (ebenso Polyzid) kommen folgende Antireflexschichten in Frage:
- Siliziumnitrid zwischen Oxid und Polysilizium. Die Schichtdicke des Nitrids muß dabei in engen Grenzen (57 bis 67 nm) gehalten werden. An Stufen (Topographie unter der Lackschicht) mit weniger als 40° Neigung kann die Reflektivität in den Fotolack unter 15 % gehalten werden.
- aSiN zwischen Oxid und Polysilizium, wobei beispielsweise beim Sputtern in eine amorphe Siliziumschicht Stickstoff eingebaut wird. Die Dicke der aSiN-Schicht muß etwa 36 bis 62 nm betragen, die Reflektivität in den Lack beträgt dann bis zu 15 %.

In beiden Fällen ist die Antireflexschicht unter der Oxidschicht angeordnet und kann in später folgenden Verfahren nicht mehr entfernt werden. Dies ist aus verschiedenen Gründen nachteilig, beispielsweise werden durch eine Nitridschicht der geforderten Dicke beträchtliche Spannungen auf die darunterliegenden Schichten ausgeübt. Ferher ist die Dicke der Oxidschicht nicht frei wählbar.

Eine weitere Antireflexschicht ist Titannitrid, wobei eine Reflexionsunterdrückung durch Lichtabsorption erreicht wird. Die Strukturierung der Titannitridschicht und insbesondere ihre Entfernungen nach der Ätzung der zu strukturierenden Schicht ist jedoch problematisch. Bei der Entfernung der Titannitridschicht muß gewährleistet sein, daß keine Reste auf der Halbleiterstruktur verbleiben, da eine solche Metallkontamination durch nachfolgende Hochtemperaturschritte die Schaltung in ihrer Funktionsfähigkeit stark beeinträchtigen kann. Daher ist Titannitrid beispielsweise für die Strukturierung in der Gateebene nicht geeignet.

Aufgabe der Erfindung ist die Angabe einer Antireflexschicht, die universell einsetzbar ist, d.h. bei jeder unterliegenden Schicht eine gute Reflexionsunterdrückung bewirkt, ohne daß sie beispielsweise in ihrer Schichtdicke speziell angepaßt werden muß. Sie soll einfach zu ätzen sein und keine nachteiligen Auswirkungen auf spätere Prozeßschritte haben. Eine weitere Aufgabe ist die Angabe eines Verfahrens, mit dem eine beliebige Schicht auf einem Halbleitersubstrat unter Einsatz einer Fotolackmaske strukturiert werden kann, bei welchem störende Reflexionen bei der Belichtung des Fotclacks weitgehend vermindert werden.

Diese Aufgaben werden durch die Patentansprüche 1, 10 und 11 gelöst.

Die Erfindung beruht auf der Verwendung einer aSi/aSiN-Doppelschicht als Antireflexschicht, wobei die Schichtdicke d so gewählt wird, daß eine ausreichende Absorption der Belichtungswellenlänge λ gewährleistet ist.

Als ausreichend wird im allgemeinen eine Absorption von 85% der in die Antireflexschicht einfallenden Intensität I₀ angesehen, so daß die geforderte Schichtdicke mindestens d = -ln 0,15/α(λ) = 1,9/α(λ) beträgt. Allgemein muß bei vorgegebener Absorption l-I/I₀ die Schichtdicke mindestens d = -ln (I/I₀)/α(λ) betragen, wobei α(λ) der z.B. mit einem Spektralellipsometer bestimmbare Absorptionskoeffizient der aSi-Schicht ist.

Bei einer Belichtung mit UV-Licht (Belichtungswellenlänge λ = 436 nm, g-line) und einem Brechungsindex von etwa 4,8 wird beispielsweise eine ca. 70 - 100 nm dicke aSi-Schicht aufgebracht. Der Vorteil der aSi/aSiN-Schicht beruht darauf, daß der Brechungsindex von aSiN zwischen dem von aSi und den üblicherweise verwendeten Fotolacken liegt. Reflexionen an der Antireflexschicht/Lack-Grenzfläche in den Lack können durch die in der aSiN-Schicht stattfindende Interferenz verringert werden. Durch die erfindungsgemäße Antireflexschicht wird eine optische Entkopplung des Untergrunds, d. h. insbesondere der zu strukturierenden Schicht, erreicht, so daß die erfindungsgemäße Antireflexschicht ohne besondere Anpassung universell einsetzbar ist.

Die Antireflexschicht ist besonders vorteilhaft einsetzbar bei i-line-Belichtung, da ohne sie die Reflektivität einer Polysilizium/Oxid-Doppelschicht bis zu 60 % beträgt.

Neben der universellen Einsetzbarkeit liegt der Vorteil der Erfindung in der Verwendung von in der Halbleitertechnologie üblichen Materialien, die kein Prozeßrisiko darstellen und für die eine Vielzahl von Ätzprozessen bekannt sind. Diese Ätzprozesse garantieren in Verbindung mit der überall gleichen Schichtdicke der Antireflexschicht beispielsweise eine gute Maßhaltigkeit bei ihrer Strukturierung. Die Antireflexschicht kann nach der Strukturierung der unterliegenden Schicht oder Schichten einfach entfernt werden, sie kann aber auch auf der Schicht verbleiben und eventuell vollständig oxidiert werden. Die elektrischen Eigenschaften der Schaltung oder nachfolgende Prozeßschritte werden durch das erfindungsgemäße Verfahren nicht beeinträchtigt.

Die Erfindung wird im folgenden anhand eines in den Zeichnungen dargestellten Ausführungsbeispiels näher erläutert.

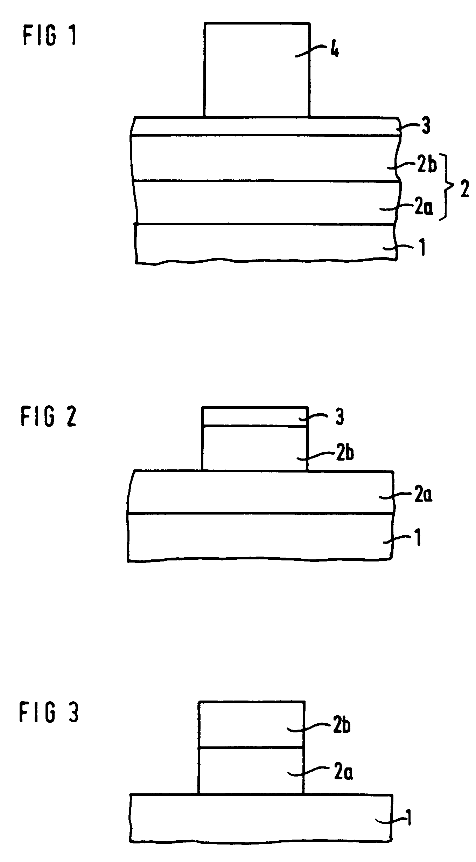

Figur 1 bis 3 zeigt die Schritte einer Ausführungsform des Verfahrens und der Halbleiterstruktur gemäß der Erfindung anhand eines Querschnitts durch eine Halbleiterstruktur.

Figur 1: Auf einem Halbleitersubstrat 1 befindet sich als zu strukturierende Schicht 2 eine Doppelschicht bestehend aus Siliziumoxid als oberer Teilschicht 2b und Polysilizium als unterer Teilschicht 2a. Darüber ist ganzflächig eine aSi/aSiN-Schicht 3 beispielsweise durch Sputterprozesse aufgebracht, wobei die Schichtdicken vorzugsweise etwa 70 - 100 nm aSi und darüber 45-65 nm aSiN betragen. Die geeignetste Schichtdicke ist dabei unter anderem abhängig von den Brechungsindizes und Absorptionskoeffizienten α(λ) von aSi, aSi/N und Fotolack, sowie der Belichtungswellenlänge λ, nicht aber von den Eigenschaften der unterliegenden Schichten 2a, 2b oder (nicht dargestellten) weiter unterliegenden Schichten.

Im Ausführungsbeispiel beträgt der Brechungsindex (Realteil) von aSi bei λ = 436 nm etwa 4,8 von aSiN etwa 2,3, der Absorptionskoeffizient von aSi etwa 19 µm⁻¹.

Die Dicken der zu strukturierenden Schichten sind frei wählbar. Auf der Antireflexschicht 3 befindet sich die Fotolackmaske 4, die durch Aufbringen, Belichten (Belichtungswellenlänge λ = 436 nm) und Entwickeln einer Fotolackschicht erzeugt wurde. Aufgrund der Antireflexschicht ist beispielsweise die Linienbreitenvariation in der Fotolackmaske 4 äußerst gering.

Figur 2: Unter Verwendung der Fotolackmaske 4 wird in einem anisotropen Ätzprozeß die Antireflexschicht 3 strukturiert. Dazu wird ein Polysilizium-Ätzprozeß eingesetzt, der selektiv zu Oxid ist oder ein Polysilizium/ Oxid-Ätzprozeß, der ebenfalls für die Oxidätzung verwendet wird. Im ersten Fall wird anschließend mit einem weiteren Ätzprozeß das Oxid 2b an den freiliegenden Stellen geätzt. Schließlich wird die Fotolackmaske 4 entfernt.

Figur 3: Vorzugsweise wird nun zunächst das freiliegende aSiN geätzt. Die Ätzung kann selektiv zu Polysilizium 2a sein oder mit einem Ätzprozeß erfolgen, der auch für die Polysilizium-Ätzung verwendet wird. Dann wird Polysilizium geätzt unter Verwendung der noch darüber vorhandenen Schichten als Maske. Vorzugsweise wird dabei gleichzeitig die restliche Antireflexschicht (aSi 3) entfernt, so daß gegen Ende der Ätzung nur die Oxidschicht 2b die Maske darstellt. Durch die relativ lange Überätzzeit (z. B. bei der Ätzung der Polysiliziumschicht für Transistorgates) kann auch eine relativ dicke aSi-Schicht sicher entfernt werden. Der Ätzprozeß muß ausreichend selektiv zu Oxid sein.

Das Verfahren kann an mehreren Stellen variiert werden. So kann beispielsweise die Lackmaske nur für die Strukturierung der Antireflexschicht 3 verwendet und anschließend entfernt werden. Die Strukturierung der Schicht (hier des Oxids) erfolgt dann mit der Antireflexschicht als Maske unter Einsatz eines entsprechend selektiven Ätzprozesses. Die Lackmaske kann auch entfernt werden, bevor die Antireflexschicht an den freiliegenden Stellen vollständig durchgeätzt ist. Die Antireflexschicht kann im Anschluß an die Strukturierung der Schicht oder Mehrfachschicht selektiv entfernt werden oder auf der Halbleiterstruktur verbleiben sowie gegebenenfalls in eine nichtleitende Schicht, z. B. durch Oxidation umgewandelt werden. Die aSiN-und aSi-Schicht kann gegebenenfalls mit einem Ätzprozess entfernt werden.

## Patentansprüche

1. Verfahren zur Strukturierung einer Schicht (2) auf einem Halbleitersubstrat (1) unter Einsatz einer Fotolackmaske(4) und eines Ätzprozesses,
bei dem vor Erzeugung der Fotolackmaske (4) eine aSi/aSiN-Doppelschicht (3), bei der die aSiN-Schicht auf der aSi-Schicht angeordnet ist, als Antireflexschicht aufgebracht wird und
bei dem die Schichtdicke d der aSi-Schicht im wesentlichen der Bedingung
d ≥ - ln (I/Iₒ)/α(λ) genügt, wobei α(λ) der Absorptionskoeffizient der aSi-Schicht bei der Belichtungswellenlänge λ ist und (1-I/Io) die vorgegebene Absorption in der Antireflexschicht ist.

2. Verfahren nach Anspruch 1 mit folgenden Schritten:
- Aufbringen der Antireflexschicht (3) auf der Schicht (2)
- Erzeugung der Fotolackmaske (4) durch Aufbringen, Belichten und Entwickeln eines Fotolacks
- Entfernen der Antireflexschicht (3) an den freiliegenden Stellen in einem Ätzprozeß
- Entfernen der Schicht (2) an den freiliegenden Stellen in einem Ätzprozeß
- Entfernen der Fotolackmaske (4).

3. Verfahren nach einem der Ansprüche 1 bis 2, bei welchem der Schritt:
Entfernen der Fotolackmaske (4) vor dem Schritt:
Entfernen der Schicht (2) an den freiliegenden Stellen in einem Ätzprozeß durchgeführt wird.

4. Verfahren nach einem der Ansprüche 1 bis 3,
**dadurch gekennzeichnet,** daß eine 70 - 100 nm dicke aSi-Schicht mit einer darüberliegenden 45 - 65 nm dicken aSiN-Schicht als Antireflexschicht (3) verwendet wird.

5. Verfahren nach einem der Ansprüche 2 bis 4,
**dadurch gekennzeichnet,** daß im Anschluß der Schritt
- Entfernen der Antireflexschicht (3) durchgeführt wird.

6. Verfahren nach einem der Ansprüche 2 bis 4,
**dadurch gekennzeichnet,** daß im Anschluß die Antireflexschicht (3) oxidiert wird.

7. Verfahren nach einem der Ansprüche 1 bis 6,
**dadurch gekennzeichnet,** daß als Schicht (2) eine Mehrfachschicht (2a, 2b) verwendet wird.

8. Verfahren nach Anspruch 7,
**dadurch gekennzeichnet,** daß beim Entfernen der Schicht (2) an den freiliegenden Stellen in dem Verfahrensschritt zunächst nur eine obere Teilschicht (2b) der Mehrfachschicht entfernt wird und im Anschluß an den letzten Verfahrensschritt oder gleichzeitig mit der Entfernung der Antireflexschicht (3) der Verfahrensschritt
- Entfernen einer unteren Teilschicht (2a) der Mehrfachschicht an ihren freiliegenden Stellen in einem Ätzprozeß durchgeführt wird.

9. Verfahren nach Anspruch 8,
**dadurch gekennzeichnet,** daß bei der Entfernung der Antireflexschicht (3) zunächst die aSiN-Schicht entfernt wird und dann die aSi-Schicht und die untere Teilschicht (2a) gleichzeitig entfernt werden.

10. Verwendung einer aSi/aSiN-Doppelschicht (3), bei der die aSiN-Schicht auf der aSi-Schicht angeordnet ist, als Antireflexschicht bei der lithografischen Strukturierung einer auf einem Halbleitersubstrat (1) aufgebrachten Schicht oder Mehrfachschicht (2), wobei die Schichtdicke d der aSi-Schicht im wesentlichen der Bedingung d ≥ - ln (I/Iₒ)/α(λ) genügt, wobei α(λ) der Absorptionskoeffizient der aSi-Schicht bei der Belichtungswellenlänge λ ist und (1-I/Io) die vorgegebene Absorption in der Antireflexschicht ist.

11. Halbleiterstruktur mit
- einer zu strukturierenden Schicht (2) oder Mehrfachschicht auf einem Halbleitersubstrat (1),
- einer darauf aufgebrachten aSi/aSiN-Doppelschicht (3), bei der die aSiN-Schicht auf der aSi-Schicht angeordnet ist, als Antireflexschicht, wobei die Schichtdicke d der aSi-Schicht im wesentlichen der Bedingung d ≥ - ln (I/Iₒ)/α(λ) genügt, wobei α(λ) der Absorptionskoeffizient der aSi-Schicht bei der Belichtungswellenlänge λ und (1-I/Io) die vorgegebene Absorption in der Antireflexschicht ist.

## Claims

1. Process for structuring a layer (2) on a semiconductor substrate (1) using a photoresist mask (4) and an etching process,
in which, before generating the photoresist mask (4), an aSi/aSiN double layer (3), in which the aSiN layer is arranged on the aSi layer, is applied as antireflexion layer and
in which the layer thickness d of the aSi layer essentially satisfies the condition d ≥ - 1n (I/Iₒ)/α(λ), where α(λ) is the absorption coefficient of the aSi layer at the exposure wavelength λ and (1-I/Io) is the given absorption in the antireflexion layer.

2. Process according to Claim 1, comprising the following steps:
- application of the antireflexion layer (3) to the layer (2),
- generation of the photoresist mask (4) by applying, exposing and developing a photoresist,
- removal, in an etching process, of the antireflexion layer (3) at the points laid bare,
- removal, in an etching process, of the layer (2) at the points laid bare,
- removal of the photoresist mask (4).

3. Process according to one of Claims 1 to 2, in which the step:
removal of the photoresist mask (4) is carried out, in an etching process, before the step:
removal of the layer (2) at the points laid bare.

4. Process according to one of Claims 1 to 3, characterized in that a 70-100 nm thick aSi layer with a 45-65 nm thick aSiN layer on top of it is used as antireflexion layer (3).

5. Process according to one of Claims 2 to 4, characterized in that the step
- removal of the antireflexion layer (3) is then carried out.

6. Process according to one of Claims 2 to 4, characterized in that the antireflexion layer (3) is then oxidized.

7. Process according to one of Claims 1 to 6, characterized in that a multilayer (2a, 2b) is used as layer (2).

8. Process according to Claim 7, characterized in that, on removing the layer (2) at the points laid bare in the process step, only an upper sublayer (2b) of the multilayer is first removed and, following the last process step or at the same time as the removal of the antireflexion layer (3), the process step
- removal, in an etching process, of a lower sublayer (2a) of the multilayer is carried out at its points laid bare.

9. Process according to Claim 8, characterized in that, during the removal of the antireflexion layer (3), the aSiN layer is first removed and then the aSi layer and the lower sublayer (2a) are removed simultaneously.

10. Use of an aSi/aSiN double layer (3), in which the aSiN layer is arranged on the aSi layer, as antireflexion layer in the lithographic patterning of a layer or multilayer (2) applied to a semiconductor substrate (1), the layer thickness d of the aSi layer essentially satisfying the condition d ≥ -ln (I/Iₒ)/α(λ), where α(λ) is the absorption coefficient of the aSi layer at the exposure wavelength λ and (1-I/Io) is the given absorption in the antireflexion layer.

11. Semiconductor structure comprising
- a layer (2) or multilayer to be structured on a semiconductor substrate (1),
- an aSi/aSiN double layer (3) applied thereto, in which the aSiN layer is arranged on the aSi layer, as antireflexion layer, the layer thickness d of the aSi layer essentially satisfying the condition d ≥ -ln (I/Iₒ)/α(λ), α(λ) being the absorption coefficient of the aSi layer at the exposure wavelength λ and (1-I/Io) being the given absorption in the antireflexion layer.

## Revendications

1. Procédé pour structurer une couche (2) sur un substrat semi-conducteur (1) par utilisation d'une photoréserve (4) et d'un procédé de gravure,
dans lequel, avant la production de la photoréserve (4), on applique en tant que couche antiréfléchissante, une couche double d'aSi/aSiN (3), où la couche d'aSiN est disposée sur la couche d'aSi, et
dans lequel l'épaisseur d de la couche d'aSi satisfait sensiblement à la condition d ≥ - In (I/I₀)α(λ), où α(λ) est le coefficient d'absorption de la couche d'aSi pour la longueur d'onde d'exposition λ, et (1-I/I₀) est l'absorption prédéfinie dans la couche antiréfléchissante.

2. Procédé selon la revendication 1, comportant les étapes suivantes :
- application de la couche antiréfléchissante (3) sur la couche (2),
- production de la photoréserve (4) par application, exposition et développement d'un vernis de photoréserve,
- enlèvement de la couche antiréfléchissante (3) en les points dégagés, dans une opération de gravure,
- enlèvement de la couche (2) en les points dégagés dans une opération de gravure,
- enlèvement de la photoréserve (4).

3. Procédé selon l'une des revendications 1 ou 2, dans lequel l'étape d'enlèvement de la photoréserve (4) est mise en oeuvre avant l'étape d'enlèvement de la couche (2) en les points dégagés dans une opération de gravure.

4. Procédé selon l'une des revendications 1 à 3, caractérisé en ce qu'on utilise en tant que couche antiréfléchissante (3) une couche d'aSi de 70 à 100 nm d'épaisseur, sur laquelle se trouve une couche d'aSiN de 45 à 65 nm d'épaisseur.

5. Procédé selon l'une des revendications 2 à 4, caractérisé en ce qu'on procède ensuite à l'étape d'enlèvement de la couche antiréfléchissante (3).

6. Procédé selon l'une des revendications 2 à 4, caractérisé en ce qu'on procède ensuite à l'oxydation de la couche antiréfléchissante (3).

7. Procédé selon l'une des revendications 1 à 6, caractérisé en ce qu'on utilise en tant que couche (2) une multicouche (2a, 2b).

8. Procédé selon la revendication 7, caractérisé en ce que, lors de l'enlèvement de la couche (2) en les points dégagés dans l'étape du procédé, on enlève d'abord seulement une couche partielle supérieure (2b) de la multicouche, puis, après la dernière opération, ou simultanément avec l'enlèvement de la couche antiréfléchissante (3), on procède à l'étape d'enlèvement d'une couche partielle inférieure (2a) de la multicouche, en ses points dégagés dans une opération de gravure.

9. Procédé selon la revendication 8, caractérisé en ce que, lors de l'enlèvement de la couche ahtiréfléchissante (3), on enlève d'abord la couche d'aSiN, puis on enlève simultanément la couche d'aSi et la couche partielle inférieure (2a).

10. Utilisation d'une couche double d'aSi/aSiN (3), dans laquelle la couche d'aSiN est disposée au-dessus de la couche d'aSi, en tant que couche antiréfléchissante lors de la structuration lithographique d'une couche ou d'une multicouche (2) appliquée sur un substrat semi-conducteur (1), où l'épaisseur d de la couche d'aSi satisfait sensiblement à la condition d≥ - In (I/I₀)α(λ), où α(λ) est le coefficient d'absorption de la couche d'aSi pour la longueur d'onde d'exposition λ, et (1-I/I₀) est l'absorption prédéfinie dans la couche antiréfléchissante.

11. Structure de semi-conducteur, comportant :
- une couche à structurer (2) ou une multicouche sur un substrat semi-conducteur (1),
- une couche double d'aSi/aSiN (3), appliquée par-dessus, la couche d'aSiN étant disposée sur la couche d'aSi, en tant que couche antiréfléchissante, l'épaisseur d de la couche d'aSi satisfaisant sensiblement à la condition d ≥ - In (I/I₀)α(λ), où α(λ) est le coefficient d'absorption de la couche d'aSi pour la longueur d'onde d'exposition λ, et (1-I/I₀) est l'absorption prédéfinie dans la couche antiréfléchissante.
